# EUROPEAN PATENT APPLICATION

(11) **EP 4 489 061 A1**
(43) Date of publication of application: **08.01.2025**
(21) Application number: 22929561.3
(22) Date of filing: 30.09.2022
(51) Int. Cl.: H01L 21/677

(54) **OVERHEAD HOIST TRANSPORT VEHICLE TRACK AND AUTOMATED MATERIAL HANDLING SYSTEM**

(30) Priority: 01.03.2022 CN 202210194406; 01.03.2022 CN 202220429851 U
(71) Applicant: Meetfuture Technology (Shanghai) Co., Ltd., Shanghai 200131 (CN)
(72) Inventor: DU, Baobao, Shanghai 200131 (CN); MIAO, Feng, Shanghai 200131 (CN)
(74) Representative: Balder IP Law, S.L.
(86) International application number: PCT/CN2022/123428
(87) International publication number: WO 2023/165131

(57) **Abstract**

The present disclosure provides a travelling track for an overhead hoist vehicle and an automatic material handling system. The travelling track includes a plurality of straight sections, one or more fork sections and at least one guide track arranged over the one or more fork sections. Each straight section of the plurality of straight sections includes two straight tracks parallel to each other and configured for supporting the overhead hoist vehicle, and the plurality of straight sections and the at least one guide track are mounted overhead. Each respective fork section of the one or more fork sections includes at least one plate-shaped first bending member arranged on an inner side of a travelling direction of the overhead hoist vehicle through the each respective fork section. A first end of each respective first bending member of the at least one first bending member is connected to a first straight track of one respective straight section of the plurality of straight sections, and a second end of the each respective first bending member of the at least one first bending member is connected to a second straight track of another respective straight section of the plurality of straight sections. The at least one first bending member is configured to support the overhead hoist vehicle at the each respective fork section of the one or more fork sections. By arranging the at least one plate-shaped first bending member at each respective fork section of the travelling track, and supporting the overhead hoist vehicle by the at least one first bending member during travelling on the one or more fork sections, the wear of the overhead hoist vehicle can be reduced, and the steadiness of the overhead hoist vehicle during travelling through bends can be ensured.

## Description

The present application claims the benefit of priority to Chinese Patent Application No. 202210194406.2 filed on March 1, 2022 and to Chinese Patent Application No. 202220429851.8 filed on March 1, 2022, each of which is incorporated herein by reference in its entirety.

### TECHNICAL FIELD

Embodiments of the present disclosure relate to the field of transportation technology of the material for semiconductor equipment, and in particular to a travelling track for an overhead hoist vehicle and an automatic material handling system.

### BACKGROUND

In a semiconductor automation plant (Fabrication or Fab for short), an automatic material handling system (AMHS) is widely used to quickly and accurately transport carriers containing wafer materials (wafer pods for short) to their destinations, thereby improving production efficiency of the Fab.

In the AMHS, a travelling track for an overhead hoist transport (OHT) is usually suspended from the ceiling to facilitate overhead handling operations of the OHT. In other words, the OHT travels along the travelling track and handles wafer materials according to specified requirements.

After operating for a period of time, an AMHS in related technologies is prone to wear on the travelling wheels, guide wheels, and cornering wheels of the OHT. Moreover, travelling steadiness of the OHT at a fork section of the travelling track is prone to degrade, or even the OHT gets stuck during the travelling through the fork section.

In view of this, there is a need of a new travelling track for an overhead hoist vehicle.

### SUMMARY

Some embodiments of the present disclosure provide a travelling track for an overhead hoist vehicle including a plurality of straight sections, one or more fork sections and at least one guide track arranged over the one or more fork sections. Each straight section of the plurality of straight sections includes two straight tracks parallel to each other and configured for supporting the overhead hoist vehicle, and the plurality of straight sections and the at least one guide track are mounted overhead. Each respective fork section of the one or more fork sections includes at least one plate-shaped first bending member arranged on an inner side of a travelling direction of the overhead hoist vehicle through the each respective fork section. A first end of each respective first bending member of the at least one first bending member is connected to a first straight track of one respective straight section of the plurality of straight sections, a second end of the each respective first bending member of the at least one first bending member is connected to a second straight track of another respective straight section of the plurality of straight sections, and the first end and the second end are two ends of each first bending member of the at least one first bending member opposite to each other. The at least one first bending member is configured to support the overhead hoist vehicle at the each respective fork section of the one or more fork sections.

Some embodiments of the present disclosure provide an automatic material handling system including at least one overhead hoist vehicle and at least one travelling track for overhead hoist vehicle as illustrated above. The at least one travelling track is configured for each overhead hoist vehicle of the at least one overhead hoist vehicle to transport target items to a predetermined location.

### BRIEF DESCRIPTION OF THE DRAWINGS

In order to illustrate the technical solutions in the embodiments of the present disclosure more clearly, the drawings involved in the embodiments will be briefly described below. It is obvious that the drawings mentioned in the following description are only some embodiments of the present disclosure. For those of ordinary skill in the art, other drawings may be obtained in accordance with these drawings without any inventive effort.
FIG. 1 is a structural schematic diagram of a travelling track for an overhead hoist vehicle according to some embodiments of the present disclosure.
FIG. 2 is a structural schematic diagram of a travelling track for an overhead hoist vehicle according to some embodiments of the present disclosure and an enlarged three-dimensional structural schematic diagram of a part denoted by "a".
FIG. 3 is a structural schematic diagram of a straight track of the travelling track according to some embodiments of the present disclosure.
FIG. 4 is a structural schematic diagram of a straight track of the travelling track according to some embodiments of the present disclosure.
FIG. 5 is a structural schematic diagram of a first high-frequency cable bracket of the travelling track according to some embodiments of the present disclosure.
FIG. 6 is a structural schematic diagram of a straight track of the travelling track according to some embodiments of the present disclosure.
FIG. 7 is a structural schematic diagram of an automatic material handling system according to some embodiments of the present disclosure and an enlarged three-dimensional structural schematic diagram of a part denoted by "b".
FIG. 8 is a structural schematic diagram of an automatic material handling system according to some embodiments of the present disclosure.
FIG. 9 is a structural schematic diagram of an automatic material handling system according to some embodiments of the present disclosure.

### DETAILED DESCRIPTION OF THE EMBODIMENTS

The following is detailed description of the embodiments of the present disclosure in conjunction with the accompanying drawings.

In the following, the embodiments of the present disclosure will be illustrated in detail using specific examples. Those skilled in the art can easily understand other advantages and benefits of the present disclosure according to the content disclosed in the present disclosure. Obviously, the described embodiments are only a part of the embodiments of the present disclosure, not all of them. The present disclosure may also be implemented or applied through different implementation methods, and the details in the present disclosure may be modified or changed based on different perspectives and applications without departing from the spirit of the present disclosure. It should be noted that, without conflict, the following embodiments and the features in the embodiments may be combined with each other. Based on the embodiments of the present disclosure, other embodiments obtained by those skilled in the art without inventive effort all fall within the scope of protection of the present disclosure.

It should be noted that various aspects of the embodiments falling within the scope of the attached claims are described below. It should be evident that the aspects described in the present disclosure may be embodied in a wide variety of forms, and any specific structures and/or functions described in the present disclosure are only illustrative. Based on the present disclosure, those skilled in the art should understand that one aspect described in the present disclosure may be implemented independent of any other aspect, and that two or more of these aspects may be combined in various ways. For example, any number and aspect described in the present disclosure may be used to implement the devices and/or practical methods. Moreover, other structures and/or functionalities other than one or more of the aspects described in the present disclosure may be used to implement the devices and/or practical methods.

It should further be noted that the diagrams mentioned in the following embodiments only illustrate the basic concept of the present disclosure in a schematic manner. The diagrams only illustrate the components related to the present disclosure and are not necessarily drawn according to the actual numbers, shapes, and sizes of the components in practice. The form, number, and scale of each component in practice may be arbitrarily changed, and the layout of the components may also be more complex.

Moreover, in the following description, specific details are provided to facilitate a thorough understanding of the examples. However, those skilled in the art shall understand that the described aspects can be implemented without these specific details.

During production of semiconductors, wafers are transported by an overhead transport system. The overhead hoist vehicles travel on travelling tracks and transport wafers to a designated location according to specified requirements. An existing travelling track for an overhead hoist vehicle includes straight and bending tracks being made into an unibody structure, and the radii of the bending tracks are obtained by bending processing. The bending radii of the bending tracks are limited by this process, thereby affecting the layout of the entire track system for overhead hoist vehicles. The bending tracks obtained by the bending process has poor mechanical properties at the bending portions. When an overhead hoist vehicle travels at a bend, the weight of the overhead hoist vehicle completely acts on the bending track, which makes the bending track more prone to get damaged and affects the steadiness of the overhead hoist vehicle. In view of this, in the present disclosure, the existing bending tracks are replaced by plate-shaped first bending members 5 which support the overhead hoist vehicle when the overhead hoist vehicle travels at a fork section. In this way, the wear of the overhead hoist vehicle occurred during travelling through bends can be reduced, the steadiness of the overhead hoist vehicle during travelling through bends can be ensured. Moreover, the first bending members 5 may be made of an aluminum plate by machining, thereby being free of the influence resulting from the bending processing, and facilitating the layout of the track system for overhead hoist vehicles.

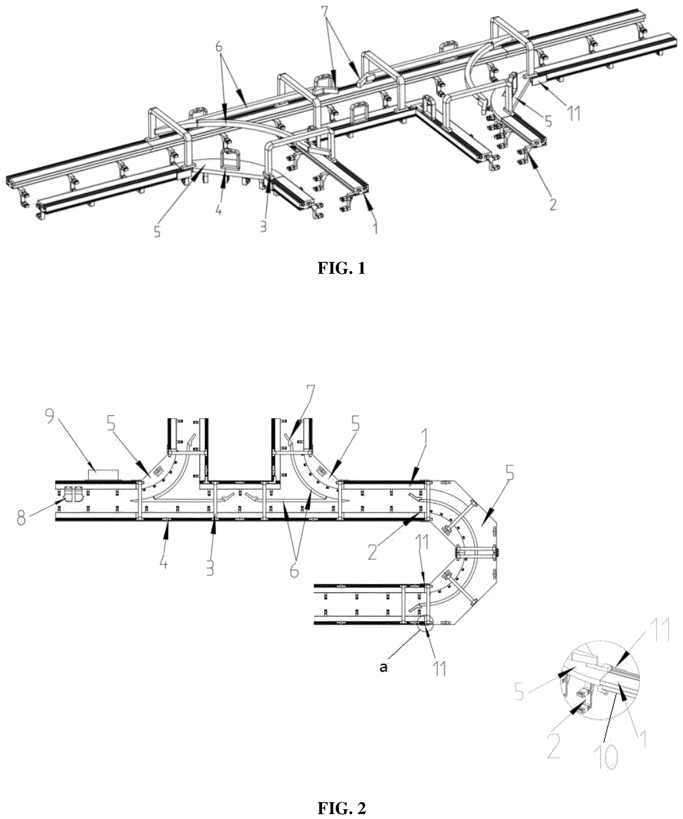

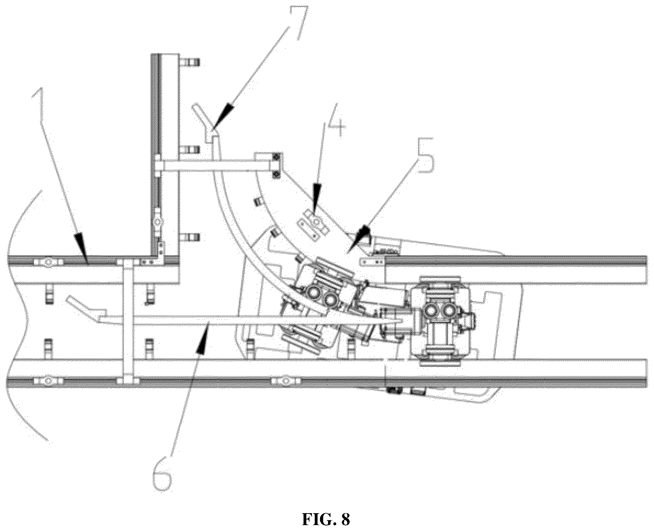

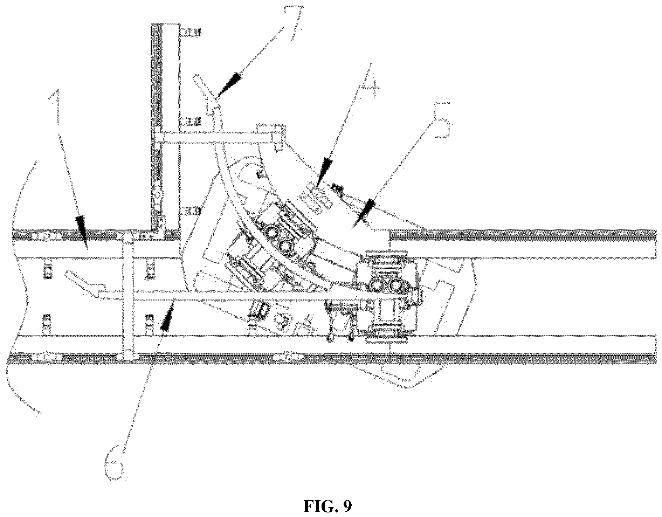

The following, in conjunction with FIGS. 1 to 9, illustrates the technical solutions provided by the embodiments of the present disclosure.

As shown in FIG. 1, a travelling track for an overhead hoist vehicle is provided. The travelling track includes a plurality of straight sections 1, one or more fork sections, and at least one guide track 6 arranged over the one or more fork sections. Each straight section of the plurality of straight sections 1 includes two straight tracks parallel to each other and configured for supporting the overhead hoist vehicle, and the plurality of straight sections 1 and the at least one guide track 6 are mounted overhead. Each respective fork section of the one or more fork sections includes at least one plate-shaped first bending member 5 arranged on an inner side of a travelling direction of the overhead hoist vehicle through the each respective fork section. A first end of each respective first bending member of the at least one first bending member 5 is connected to a first straight track of one respective straight section of the plurality of straight sections, a second end of the each respective first bending member of the at least one first bending member 5 is connected to a second straight track of another respective straight section of the plurality of straight sections, and the first end and the second end are two ends of each first bending member of the at least one first bending member 5 opposite to each other. The at least one first bending member 5 is configured to support the overhead hoist vehicle at the each respective fork section of the one or more fork sections. By providing the at least one plate-shaped first bending member 5 at each respective fork section, the overhead hoist vehicle can be supported by the at least one plate-shaped first bending member 5 during travelling through each respective fork section. In this way, wear on the travelling wheels, guide wheels and cornering wheels of the overhead hoist vehicle, and dust resulted from the wear can be reduced. Moreover, the steadiness of the overhead hoist vehicle during travelling through bends can be ensured, therefore the impact of vibration on wafers transported by the overhead hoist vehicle can be prevented. Moreover, the first bending members 5 have plate-shaped structures, thereby being free of either the influence resulting from the bending processing, or the influence of the radii. Thus, the first bending members 5 can have higher machining accuracy, thereby facilitating the layout of the track system for overhead hoist vehicles. Furthermore, compared with a bending track produced by the bending process, the first bending members 5 can have better mechanical properties, thereby ensuring support for overhead hoist vehicles.

In some embodiments, the travelling track further includes a guide member 7 arranged at an end of each guide track of the at least one guide track 6 along a travelling direction of the overhead hoist vehicle. The guide member 7 is inclined with respect to the straight track connected with the at least one first bending member 5 from a joint of the guide member 7 with a respective guide track 6 to the other end of the guide member 7, and the guide member 7 extends away from the straight track. The guide member 7 is configured for travelling of a guide wheel of the overhead hoist vehicle along the guide member 7 in response to the guide wheel travelling to the end of each guide track of the at least one guide track 6, to enable a travelling wheel of the overhead hoist vehicle suspended during travelling through the one or more fork sections to return to a respective straight track. By providing the guide member 7 at an end of each guide track of the at least one guide track 6, the guide wheel of the overhead hoist vehicle can be guided by the guide member 7 during travelling through bends, thereby ensuring the overhead hoist vehicle to travel to expected straight tracks. In this way, the overhead hoist vehicle can be prevented from tilting or falling off the tracks, and normal operation of the travelling track can be ensured.

In some embodiments, the travelling track further includes at least one first mounting member 4. A mounting portion for each first mounting member of the at least one first mounting member 4 is arranged on an upper surface of each first bending member of the at least one first bending member 5, so that the at least one first bending member 5 is mounted overhead by the at least one first mounting member 4. By arranging the at least one first mounting member 4 on the at least one first bending member 5, and mounting the at least one first bending member 5 overhead by the at least one first mounting member 4, the load-bearing capacity of the at least one first bending member 5 and therefore the steadiness of the overhead hoist vehicle when travelling on the at least one first bending member 5 can be ensured.

It is noted that due to the fact that the existing tracks are usually processed by forming the radii of bending tracks, it is generally difficult to arrange mounting member 4 on the bending tracks for lifting. During travelling of the overhead hoist vehicle at bends, the weight of the overhead hoist vehicle acts on the bending tracks. Due to the poor mechanical performance, the bending tracks is prone to deformation, resulting in poor steadiness and bumpiness of the overhead hoist vehicle during travelling through bends, thereby affecting the quality of wafers.

In some embodiments, the travelling track further includes at least one first track connection member fixedly connected on an upper surface of the first end of each first bending member of the at least one first bending member 5 and on an upper surface of the first straight track. By connecting a top of the first end of each first bending member of the at least one first bending member 5 with a top of the first straight track by the at least one first track connection member, stability between the first end of the at least one first bending member 5 and the first straight track can be ensured.

In some embodiments, the travelling track further includes at least one second track connection member fixedly connected on an upper surface of the second end of the each respective first bending member of the at least one first bending member 5 and on an upper surface of the second straight track. By connecting a top of the second end of the each respective first bending member of the at least one first bending member 5 with a top of the second straight track, stability between the second end of the at least one first bending member 5 and the second straight track can be ensured.

In some embodiments, the travelling track further includes at least one first track bottom connection member 12 fixedly connected on a lower surface of the first end of each first bending member of the at least one first bending member 5 and on a lower surface of the first straight track. By connecting a bottom of the first end of each first bending member of the at least one first bending member 5 with a bottom of the first straight track by the at least one first track bottom connection member 12, stability between the first end of the at least one first bending member 5 and the first straight track can be ensured.

In some embodiments, the travelling track further includes at least one second track bottom connection member 12 fixedly connected on a lower surface of the second end of the each respective first bending member of the at least one first bending member 5 and on a lower surface of the second straight track. By connecting a bottom of the second end of the each respective first bending member of the at least one first bending member 5 to a bottom of the second straight track by the at least one second track bottom connection member 12, stability between the second end of the at least one first bending member 5 and the second straight track can be ensured.

In some embodiments, the travelling track further includes at least one first track sidewall connection member 11 fixedly connected on a first lateral surface of the first end of each first bending member of the at least one first bending member 5 and on a first lateral surface of the first straight track. By connecting the first lateral surface of the first end of each first bending member of the at least one first bending member 5 with the first lateral surface of the first straight track by the at least one first track sidewall connection member 11, stability between the first end of the at least one first bending member 5 and the first straight track can be ensured.

In some embodiments, the travelling track further includes at least one second track sidewall connection member 11 fixedly connected on a second lateral surface of the second end of the each respective first bending member of the at least one first bending member 5 and on a second lateral surface of the second straight track. By connecting the second lateral surface of the second end of the each respective first bending member of the at least one first bending member 5 with the second lateral surface of the second straight track by the at least one second track sidewall connection member 11, stability between the second end of the at least one first bending member 5 and the second straight track can be ensured.

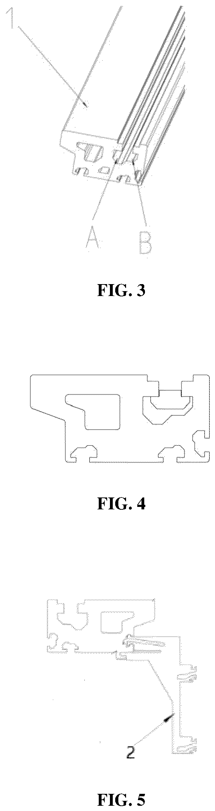

As shown in FIG. 5, in some embodiments, the travelling track further includes a plurality of first high-frequency cable brackets 2 for installing high-frequency cables. Each respective first high-frequency cable bracket of the plurality of first high-frequency cable brackets 2 includes a first mounting leg, a second mounting leg and one or more hooks for holding the high-frequency cables. By providing the plurality of first high-frequency cable brackets 2, high-frequency cables can be installed, thereby ensuring normal operation of the overhead hoist vehicle. By holding the high-frequency cables using the one or more hooks, installation of the high-frequency cables can be facilitated.

One respective straight track of the two straight tracks of each straight section of the plurality of straight sections has, on a side facing to the other respective straight track of the two straight tracks, a first mounting groove and a second mounting groove extending along a travelling direction of the overhead hoist vehicle. The first mounting leg is snap fitted at a first position in the first mounting groove, and the second mounting leg is snap fitted at a second position in the second mounting groove, to enable the each respective first high-frequency cable bracket of the plurality of first high-frequency cable brackets to be arranged in a specified position on the one respective straight track of the two straight tracks of each straight section of the plurality of straight sections. By defining the first and second mounting grooves on an inner side of a respective straight track, fitting the first mounting leg in the first mounting groove, and fitting the second mounting leg in the second mounting groove, the plurality of first high-frequency cable brackets 2 can be arranged in any specified position on the respective straight track, thereby facilitating the mounting of the plurality of high-frequency cable brackets, and ensuring the support stability of the plurality of high-frequency cable brackets for the high-frequency cables.

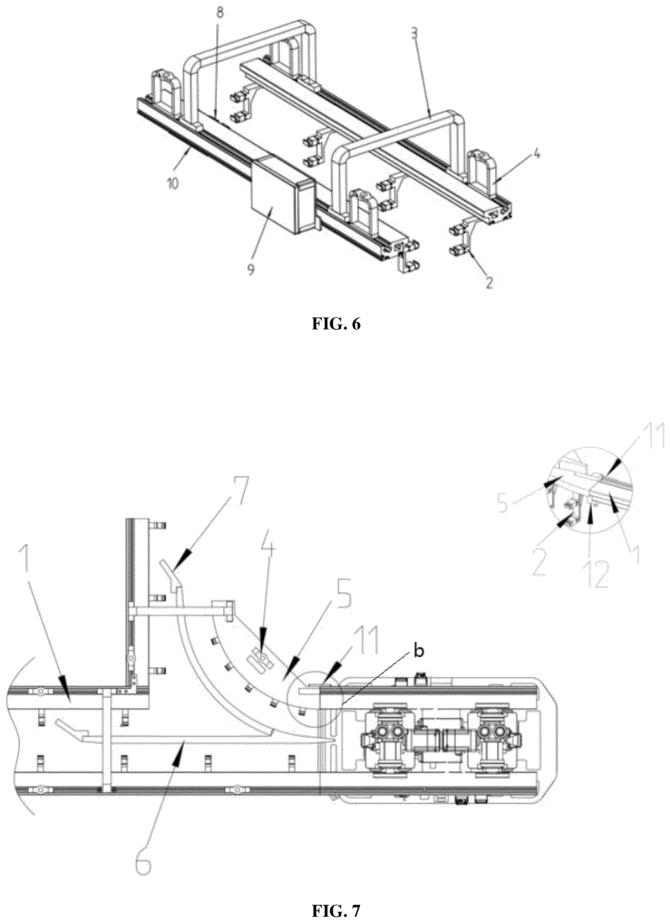

As shown in FIG. 6, in some embodiments, the travelling track further includes a plurality of track connection arms 3 and/or at least one second mounting member 4. An upper portion of each respective straight track of the two straight tracks of each straight section of the plurality of straight sections has a first nut installation groove extending along the travelling direction of the overhead hoist vehicle, and a bottom of the first nut installation groove is shaped to have two planes at different heights, such that during installation of a first nut in the first nut installation groove, one end of the first nut falls on a lower plane of the two planes of the first nut installation groove, to enable another end of the first nut to enter the first nut installation groove, in order to fix, by the first nut, one respective track connection arm of the plurality of track connection arms 3 or the at least one second mounting member 4 to the each respective straight track at a first specified position on the each respective straight track. By defining the first nut installation groove having asymmetric structure in the upper portion of each respective straight track, the bottom of the first nut installation groove is shaped to have two planes at different heights. Using this structure, the first nut can be installed sideling in the first nut installation groove, without need of installing the first nuts one by one at an end of each respective straight track. In this way, the first nut can be arbitrarily installed at any position on the straight track, without need of adapting the size of the first nut, thereby facilitating the installation of the straight tracks.

As shown in FIG. 6, in some embodiments, the travelling track further includes at least one capacitor box 9.

As shown in FIGS. 3 and 4, one respective straight track of the two straight tracks of each straight section of the plurality of straight sections has, on a side facing away from the other respective straight track of the two straight tracks, a second nut installation groove extending along the travelling direction of the overhead hoist vehicle. A bottom of the second nut installation groove is shaped to have two planes at different heights, such that during installation of a second nut in the second nut installation groove, one end of the second nut falls on a lower plane of the two planes of the second nut installation groove, to enable another end of the second nut to enter the second nut installation groove, in order to fix, by the second nut, the at least one capacitor box 9 to the each respective straight track at a second specified position on the each respective straight track. By defining the second nut installation groove having asymmetric structure on an outer side of one respective straight track, the at least one capacitor box 9 can be fixed to each straight track at any specified position on each straight track by the second nut, thereby facilitating the installation of the at least one capacitor box 9.

As shown in FIG. 6, in some embodiments, the travelling track further includes at least one first position sensing device 10.

As shown in FIGS. 3 and 4, a bottom of each respective straight track of the two straight tracks of each straight section of the plurality of straight sections has a third nut installation groove extending along the travelling direction of the overhead hoist vehicle. A bottom of the third nut installation groove is shaped to have two planes at different heights, such that during installation of a third nut in the third nut installation groove, one end of the third nut falls on a lower plane of the two planes of the third nut installation groove, to enable another end of the third nut to enter the third nut installation groove, in order to fix, by the third nut, the at least one first position sensing device 10 to the each respective straight track at a third specified position on the each respective straight track. By defining the third nut installation groove having asymmetric structure in the bottom of each straight track, the at least one first position sensing device 10 can be fixed to each straight track at any specified position on each straight track by the third nut, thereby facilitating the installation of the at least one first position sensing device 10.

In some embodiments, the travelling track further includes at least one elbow bracket 8.

One respective straight track of the two straight tracks of each straight section of the plurality of straight sections has, on the side facing to the other respective straight track of the two straight tracks, a fourth nut installation groove extending along the travelling direction of the overhead hoist vehicle. A bottom of the fourth nut installation groove is shaped to have two planes at different heights, such that during installation of a fourth nut in the fourth nut installation groove, one end of the fourth nut falls on a lower plane of the two planes of the fourth nut installation groove, to enable another end of the fourth nut to enter the fourth nut installation groove, in order to fix, by the fourth nut, the at least one elbow bracket 8 to the each respective straight track at a fourth specified position on the each respective straight track.

In some embodiments, a plane in which an opening of the first nut installation groove locates is lower than a plane on which a travelling wheel of the overhead hoist vehicle supports. In this way, the travelling wheel of the overhead hoist vehicle can be free of influence, thereby ensuring normal travelling of the overhead hoist vehicle. The opening has a first width, to enable a connection portion of one respective track connection arm of the plurality of track connection arms 3 or a connection portion of each second mounting member of the at least one second mounting member 4 to insert the opening and connect with one respective straight track of the two straight tracks of each straight section of the plurality of straight sections.

As shown in FIG. 2, in some embodiments, the travelling track further includes at least one bending section. Each respective bending section of the at least one bending section includes a bridging arm and a plurality of plate-shaped second bending members, and the plurality of plate-shaped second bending members are arranged in the each respective bending section of the at least one bending section. One end of the bridging arm is connected to one respective second bending member of the plurality of second bending members arranged on an inner side of the each respective bending section of the at least one bending section, and the other end of the bridging arm is connected to one respective second bending member of the plurality of second bending members arranged on an outer side of the each respective bending section of the at least one bending section. By constituting each bending section of the at least one bending section using the bridging arm and the plurality of plate-shaped second bending members, and connecting the one respective second bending member on the inner side of each respective bending section of the at least one bending section and the one respective second bending member on the outer side of each respective bending section of the at least one bending section by the bridging arm, the overhead hoist vehicle can implement a turn of 180 degrees.

As shown in FIG. 2, in some embodiments, a lower portion of each second bending member of the plurality of second bending members has a plurality of first mounting components configured for mounting a plurality of second high-frequency cable brackets. By mounting the plurality of second high-frequency cable brackets using the plurality of first mounting components arranged on the lower portion of each second bending member, and installing the second high-frequency cables using the plurality of second high-frequency cable brackets, normal operation of the overhead hoist vehicle can be ensured.

As shown in FIG. 2, in some embodiments, the lower portion of each second bending member of the plurality of second bending members has a plurality of second mounting components configured for mounting a plurality of second position sensing devices. By mounting the plurality of second position sensing devices using the plurality of second bending members arranged on the lower portion of each second bending member, the position of the overhead hoist vehicle during travelling through bends can be monitored by the plurality of second position sensing devices.

In some embodiments, the at least one first bending member 5 is made of an aluminum plate by machining. Compared with bending processing technology, this process can be free of the limitation of processing radii, have higher processing accuracy, and provide more selectivity to the layout of the track system for overhead hoist vehicles.

In some embodiments, the two straight tracks of each straight section of the plurality of straight sections are made of aluminum profiles. In this way, the weight of the tracks can be reduced while the load-bearing requirements of the overhead hoist vehicle can be met.

As shown in FIGS. 7 to 9, the present disclosure provides, based on the same invention concept, an automatic material handling system including at least one overhead hoist vehicle and at least one travelling track for the overhead hoist vehicle as illustrated above. The at least one travelling track is configured for each overhead hoist vehicle of the at least one overhead hoist vehicle to transport target items to a predetermined location.

It should be noted that by transporting materials using the overhead hoist vehicle along the travelling track, the steadiness of the overhead hoist vehicle during travelling through bends can be ensured, the wear of the overhead hoist vehicle occurred during travelling through bends can be reduced, and normal operation of the automatic material handling system can be ensured.

The embodiments of the present disclosure are described in a progressive manner, and the same and similar parts between each embodiment may be referred to each other. Each embodiment focuses on describing the differences from other embodiments. Especially for the method embodiments described later, as they correspond to the system, the description is relatively simple, and reference may be made to the description of the system embodiments for relevant details.

The above are only the specific embodiments of the present disclosure, but the scope of protection of the present disclosure is not limited to this. Any changes or replacements that are easily conceivable to those skilled in the art within the scope of disclosure of the present disclosure shall fall within the scope of protection of the present disclosure. Therefore, the protection scope of the present disclosure should be determined by the protection scope of the claims.

## Claims

1. A travelling track for an overhead hoist vehicle, comprising:
a plurality of straight sections (1);
one or more fork sections; and
at least one guide track (6) arranged over the one or more fork sections;
wherein each straight section of the plurality of straight sections (1) includes two straight tracks parallel to each other and configured for supporting the overhead hoist vehicle, and the plurality of straight sections (1) and the at least one guide track (6) are mounted overhead;
wherein each respective fork section of the one or more fork sections includes at least one plate-shaped first bending member (5) arranged on an inner side of a travelling direction of the overhead hoist vehicle through the each respective fork section, a first end of each respective first bending member of the at least one first bending member (5) is connected to a first straight track of one respective straight section of the plurality of straight sections, a second end of the each respective first bending member of the at least one first bending member (5) is connected to a second straight track of another respective straight section of the plurality of straight sections, and the first end and the second end are two ends of each first bending member of the at least one first bending member (5) opposite to each other; and
wherein the at least one first bending member (5) is configured to support the overhead hoist vehicle at the each respective fork section of the one or more fork sections.

2. The travelling track according to claim 1, further including a guide member (7) arranged at an end of each guide track of the at least one guide track (6) along a travelling direction of the overhead hoist vehicle;
wherein the guide member (7) is configured for travelling of a guide wheel of the overhead hoist vehicle along the guide member (7) in response to the guide wheel travelling to the end of each guide track of the at least one guide track (6), to enable a travelling wheel of the overhead hoist vehicle suspended during travelling through the one or more fork sections to return to a respective straight track.

3. The travelling track according to claim 2, further including at least one first mounting member (4), wherein a mounting portion for each first mounting member of the at least one first mounting member (4) is arranged on an upper surface of each first bending member of the at least one first bending member (5), to enable the at least one first bending member (5) to be mounted overhead by the at least one first mounting member (4).

4. The travelling track according to claim 1, further including at least one first track connection member fixedly connected on an upper surface of the first end of each first bending member of the at least one first bending member (5) and on an upper surface of the first straight track, to connect the first end of each first bending member of the at least one first bending member (5) to the first straight track; and/or
further including at least one second track connection member fixedly connected on an upper surface of the second end of each first bending member of the at least one first bending member (5) and on an upper surface of the second straight track, to connect the second end of each first bending member of the at least one first bending member (5) to the second straight track; and/or
further including at least one first track bottom connection member (12) fixedly connected on a lower surface of the first end of each first bending member of the at least one first bending member (5) and on a lower surface of the first straight track, to connect the first end of each first bending member of the at least one first bending member (5) to the first straight track; and/or
further including at least one second track bottom connection member (12) fixedly connected on a lower surface of the second end of each first bending member of the at least one first bending member (5) and on a lower surface of the second straight track, to connect the second end of each first bending member of the at least one first bending member (5) to the second straight track; and/or
further including at least one first track sidewall connection member (11) fixedly connected on a first lateral surface of the first end of each first bending member of the at least one first bending member (5) and on a first lateral surface of the first straight track, to connect the first end of each first bending member of the at least one first bending member (5) to the first straight track; and/or
further including at least one second track sidewall connection member (11) fixedly connected on a second lateral surface of the second end of each first bending member of the at least one first bending member (5) and on a second lateral surface of the second straight track, to connect the second end of each first bending member of the at least one first bending member (5) to the second straight track.

5. The travelling track according to claim 1, further including a plurality of first high-frequency cable brackets (2) for installing high-frequency cables, wherein each respective first high-frequency cable bracket of the plurality of first high-frequency cable brackets (2) includes a first mounting leg, a second mounting leg and one or more hooks for holding the high-frequency cables;
wherein one respective straight track of the two straight tracks of each straight section of the plurality of straight sections (1) has, on a side facing to another respective straight track of the two straight tracks, a first mounting groove and a second mounting groove extending along a travelling direction of the overhead hoist vehicle, and wherein the first mounting leg is snap fitted at a first position in the first mounting groove, and the second mounting leg is snap fitted at a second position in the second mounting groove, to enable the each respective first high-frequency cable bracket of the plurality of first high-frequency cable brackets (2) to be arranged in a specified position on the one respective straight track of the two straight tracks of each straight section of the plurality of straight sections (1); and/or
the travelling track further includes a plurality of track connection arms (3) and/or at least one second mounting member (4), wherein an upper portion of each respective straight track of the two straight tracks of each straight section of the plurality of straight sections (1) has a first nut installation groove extending along the travelling direction of the overhead hoist vehicle, and a bottom of the first nut installation groove is shaped to have two planes at different heights, such that during installation of a first nut in the first nut installation groove, one end of the first nut falls on a lower plane of the two planes of the first nut installation groove, to enable another end of the first nut to enter the first nut installation groove, in order to fix, by the first nut, one respective track connection arm of the plurality of track connection arms (3) or the at least one second mounting member (4) to the each respective straight track at a first specified position on the each respective straight track; and/or
the travelling track further includes at least one capacitor box (9);
wherein one respective straight track of the two straight tracks of each straight section of the plurality of straight sections (1) has, on a side facing away from another respective straight track of the two straight tracks, a second nut installation groove extending along the travelling direction of the overhead hoist vehicle, and wherein a bottom of the second nut installation groove is shaped to have two planes at different heights, such that during installation of a second nut in the second nut installation groove, one end of the second nut falls on a lower plane of the two planes of the second nut installation groove, to enable another end of the second nut to enter the second nut installation groove, in order to fix, by the second nut, the at least one capacitor box (9) to the each respective straight track at a second specified position on the each respective straight track; and/or
the travelling track further includes at least one first position sensing device (10);
wherein a bottom of each respective straight track of the two straight tracks of each straight section of the plurality of straight sections (1) has a third nut installation groove extending along the travelling direction of the overhead hoist vehicle, and wherein a bottom of the third nut installation groove is shaped to have two planes at different heights, such that during installation of a third nut in the third nut installation groove, one end of the third nut falls on a lower plane of the two planes of the third nut installation groove, to enable another end of the third nut to enter the third nut installation groove, in order to fix, by the third nut, the at least one first position sensing device (10) to the each respective straight track at a third specified position on the each respective straight track; and/or
the travelling track further includes at least one elbow bracket (8);
wherein one respective straight track of the two straight tracks of each straight section of the plurality of straight sections (1) has, on the side facing to another respective straight track of the two straight tracks, a fourth nut installation groove extending along the travelling direction of the overhead hoist vehicle, and wherein a bottom of the fourth nut installation groove is shaped to have two planes at different heights, such that during installation of a fourth nut in the fourth nut installation groove, one end of the fourth nut falls on a lower plane of the two planes of the fourth nut installation groove, to enable another end of the fourth nut to enter the fourth nut installation groove, in order to fix, by the fourth nut, the at least one elbow bracket (8) to the each respective straight track at a fourth specified position on the each respective straight track.

6. The travelling track according to claim 5, wherein a plane in which an opening of the first nut installation groove locates is lower than a plane on which a travelling wheel of the overhead hoist vehicle supports, and the opening has a first width, to enable a connection portion of one respective track connection arm of the plurality of track connection arms (3) or a connection portion of each second mounting member of the at least one second mounting member (4) to be inserted into the opening and connect with one respective straight track of the two straight tracks of each straight section of the plurality of straight sections (1).

7. The travelling track according to claim 1, further including at least one bending section, wherein each respective bending section of the at least one bending section includes a bridging arm and a plurality of plate-shaped second bending members, and the plurality of plate-shaped second bending members are arranged in the each respective bending section of the at least one bending section, and wherein one end of the bridging arm is connected to one respective second bending member of the plurality of second bending members arranged on an inner side of the each respective bending section of the at least one bending section, and another end of the bridging arm is connected to another respective second bending member of the plurality of second bending members arranged on an outer side of the each respective bending section of the at least one bending section.

8. The travelling track according to claim 7, wherein a lower portion of each second bending member of the plurality of second bending members has a plurality of first mounting components configured for mounting a plurality of second high-frequency cable brackets; and/or
the lower portion of each second bending member of the plurality of second bending members has a plurality of second mounting components configured for mounting a plurality of second position sensing devices.

9. The travelling track according to any one of claims 1 to 8, wherein each first bending member of the at least one first bending member (5) is made of an aluminum plate by machining; and/or
the two straight tracks of each straight section of the plurality of straight sections (1) are made of aluminum profiles.

10. An automatic material handling system, comprising at least one overhead hoist vehicle and at least one travelling track for overhead hoist vehicle according to any one of claims 1 to 9, wherein the at least one travelling track is configured for each overhead hoist vehicle of the at least one overhead hoist vehicle to transport target items to a predetermined location.
